## Europäisches Patentamt
## European Patent Office
## Office européen des brevets

(19)

(11) Numéro de publication: **0 061 376**
**B1**

(12) **FASCICULE DE BREVET EUROPEEN**

(45) Date de publication du fascicule du brevet:
**08.08.84**

(21) Numéro de dépôt: **82400387.5**

(22) Date de dépôt: **05.03.82**

(51) Int. Cl.³: **H 01 L 29/80, H 01 L 29/60,
H 01 L 29/52, H 01 L 21/28**

(54) Transistor à effet de champ de type planar comportant des électrodes à puits métallisés, et procédé de fabrication de ce transistor.

(30) Priorité: **10.03.81 FR 8104719**

(43) Date de publication de la demande:
**29.09.82 Bulletin 82/39**

(45) Mention de la délivrance du brevet.
**08.08.84 Bulletin 84/32**

(84) Etats contractants désignés:
**DE GB IT NL**

(56) Documents cités:
**DE - A - 2 929 939
FR - A - 1 317 256
FR - A - 2 454 703
US - A - 3 999 281
US - A - 4 035 826**

(73) Titulaire: **THOMSON-CSF, 173, Boulevard Haussmann,
F-75379 Paris Cedex 08 (FR)**

(72) Inventeur: **Jay, Paul Robert, THOMSON-CSF
SCPI 173, bld Haussmann, F-75360 Paris Cedex 08 (FR)**

(74) Mandataire: **Taboureau, James et al, THOMSON-CSF
SCPI 173, Bld Haussmann, F-75379 Paris Cedex 08 (FR)**

BUNDESDRUCKEREI BERLIN

## Description

L'invention concerne un transistor à effet de champ de technologie planar comportant des électrodes du type »à puits métallisés« ainsi que le procédé de fabrication de ce transistor.

Dans un transistor à effet de champ de technologie planar, on trouve une structure que l'on peut qualifier de »latérale« tant par sa géométrie que par son fonctionnement. En effet, les électrodes de source, de grille et de drain sont formées ou déposées, selon qu'il y a lieu de constituer avec le semiconducteur un contact ohmique ou un contact Schottky, sur une face d'un solide semiconducteur. Parallèlement à cette rangée d'électrodes, on trouve la couche active formée par dépôt épitaxial préalable sur un substrat semiconducteur ou par implantation ionique d'impuretés dopantes dans la couche superficielle dudit substrat. En fonctionnement, le courant ne peut s'établir entre source et drain que dans la couche superficielle et la commande de ce courant a lieu par action verticale du potentiel de grille.

Cette structure et ce mode de fonctionnement présentent plusieurs inconvénients, dont on citera quelques-uns ci-après:

interface avec le substrat semi-isolant de résistivité mal contrôlée, notamment pour la réalisation de circuits intégrés en arséniure de gallium;
existence de pièges à l'interface »substrat-couche active«;
états de surface générateurs d'effets parasites sur l'étendue de la zone déserte, ce qui nuit au bon fonctionnement à bas potentiel;
résistance ohmique de l'électrod de grille trop élevée, par suite des dimensions de celle-ci, même en structure interdigitée;
résistance d'accès trop élevée au semiconducteur, notamment sur arséniure de gallium;
encombrement trop important en surface, ce qui limite la densité d'intégration.

On a proposé des structures de type vertical comportant des électrodes enterrées. Leur procédé de fabrication est difficile à mettre en oeuvre car les électrodes enterrées sont difficiles à réaliser et leur technologie exige la formation de régions semiconductrices fortement dopées pratiquement incompatible avec la présence d'un substrat semi-isolant, nécessaire dans les circuits intégrés sur arséniure de gallium.

Du document FR-A-2 454 703 est aussi connu un transistor à effet de champ, composé notamment d'une couche active, d'un premier type de conductivité, déposée sur un substrat semi-isolant. Dans ce transistor, la région de porte, qui contrôle le passage du courant entre les régions d'accès, est composée d'au moins deux zones cylindriques d'un second type de conductivité, s'étendant à travers la couche active jusqu'au substrat. Ces deux zones de second type de conductivité sont obtenues par implantation d'ions dans la couche active et sont reliéfs par une couche métallique disposé à la surface de la couche active et formant un contact Schottky avec elle.

L'implantation est un procédé efficace pour créer des régions telles que des caissons, mais très délicat pour transformer un matériau dans des régions très petites et profondes, formant peigne par exemple.

L'invention tend à remédier à la plupart de ces inconvénients.

Le transistor à effet de champ selon l'invention est du type planar. Il comporte un substrat semiconducteur comportant lui-même une région à grande résistivité électrique. Sur ce substrat, du côté de la région à grande résistivité a été déposée une couche semiconductrice active. Des électrodes de source, de grille et de drain déposées sur la couche active établissent avec celle-ci respectivement un contact ohmique, un contact Schottky et un contact ohmique.

Il est caractérisé en ce que les électrodes de source, de grille et drain sont prolongées à travers la couche active du solide semiconducteur par une pluralité de puits métallisés formant peigne jusque dans la région de grande résistivité du substrat semiconducteur et forme une rangée sutée dans un plan normal à la direction du courant drain-surce. Les puits métalliques sous l'électrode de grille formant un contact Schottky avec le matériau de la couche active tandis que les puits métalliques sous les électrodes de source et drain forment un contact ohmique avec ledit matériau.

Le procédé de fabrication du transistor selon l'invention comporte au moins les étapes telle que décrits dans la revendication 5.

Les fig. 1 et 2 représentant respectivement en perspective cavalière tronquée et en coupe longitudinale, des transistors à effet de champ comportant une rangie de puits métallisés sous l'électrode de grille.

Les fig. 3 et 4 représentent en coupe des réalisations de l'invention.

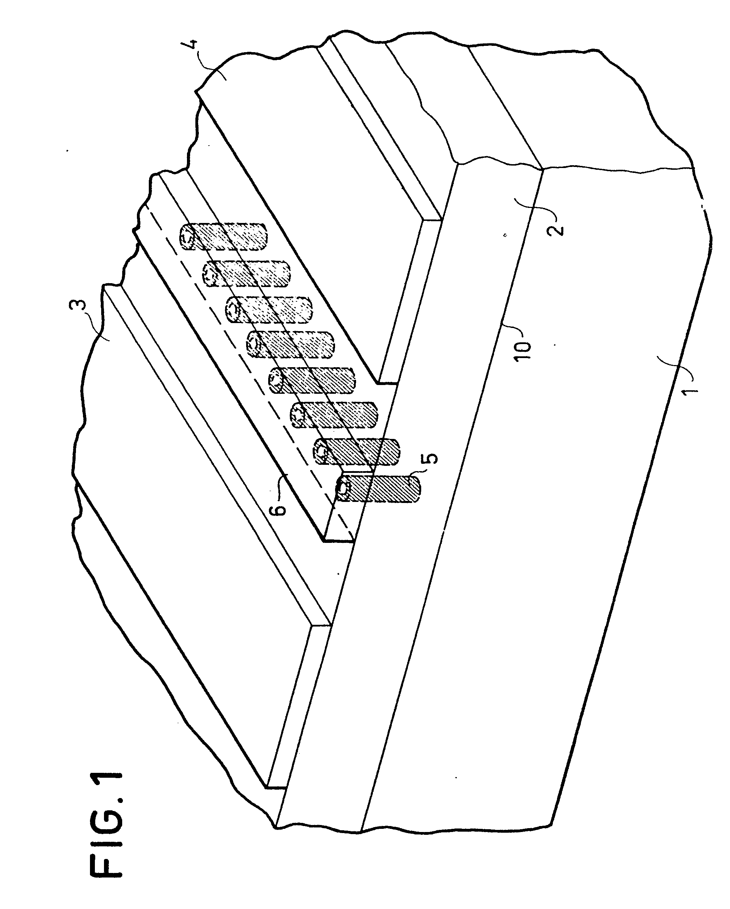

Un fragment de transistor à effet de champ est représenté en perspective cavalière à partir d'une coupe transversale, fig. 1, d'un solide semiconducteur.

On a délimité en trait plein la frontière 10 entre le substrat semiconducteur 1, par exemple en arséniure de gallium monocristallin, et une couche active 2. Celle-ci a été formée par exemple par dépôt épitaxial sur le substrat 1 en monocristal d'arséniure de gallium faiblement dopé de manière à présenter une très grande résistivité. La couche active 2 est par exemple de type n de conductivité et d'un taux de dopage de l'ordre de $8 \cdot 10^{16}$ at $\cdot$ cm $^3$.

Deux électrodes 3 et 4 sont formées sur la surface libre de la couche 2 par dépôts successifs de nickel, de germaniam et d'or, pour constituer des contacts ohmiques destinés à servir de source et de drain. Une rangée de puits métallisés 5 a été formée par le procédé mentionné ci-avant. Elle est parallèle à la grande dimension des électrodes 3 et 4 et placée entre celles-ci. La métallisation est formée par des dépôts successifs par exemple de titane, de platine et d'or. Les dimensions sont par exemple les suivantes: 0,5 à 1 micron pour le diamètre des puits espacés de 0,5 à 0,8 micron.

Ensuite la rangée est recouverte par un dépôt allongé 6 réalisé en utilisant les mêmes métaux que pour la métallisation des puits 5. Ce dépôt constitue bien l'électrode de grille 6 du transistor.

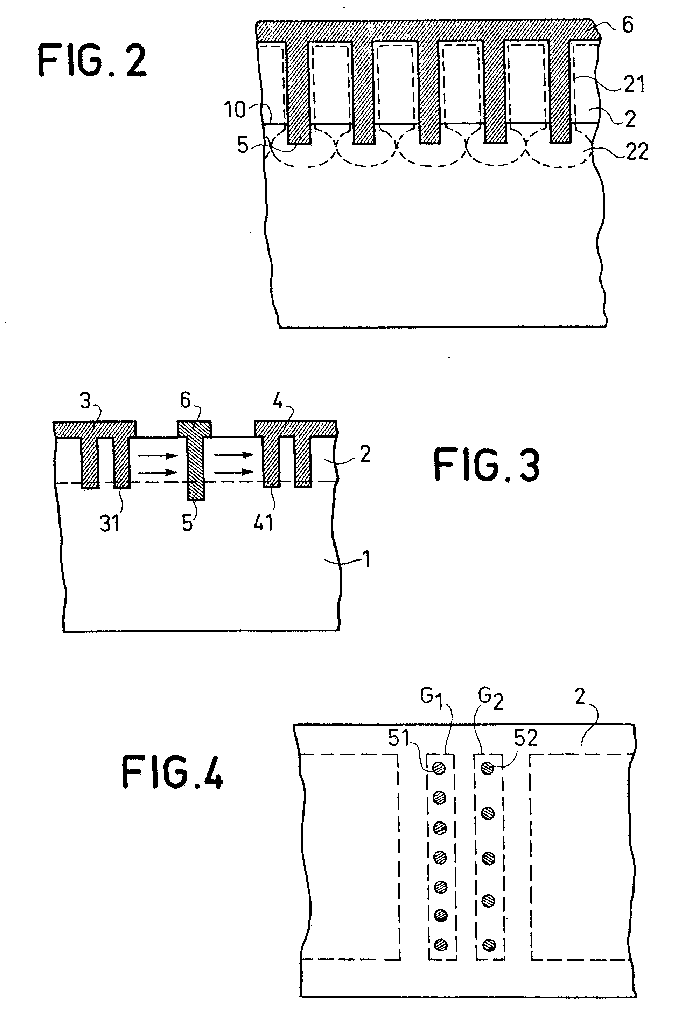

A la fig. 2, on a représenté en coupe suivant un plan perpendiculaire à la couche 2 et constituant un plan de symétrie longitudinal pour la rangée de puits 5. On a dessiné en trait interrompu la limite de la zone déserte située autour de l'électrode 6 pour un potentiel donné. Cette limite se trouve très près du contact Schottky (en 21) dans la partie de la grille plongée dans la couche 2, peu dopée, et beaucoup plus éloignée (en 22) de la grille dans le substrat moins dopé encore que la couche 2. Il en résulte que, pour ce potentiel, la région conductrice des porteurs de charge, au cours du fonctionnement du transistor, est limitée à l'espace situé entre les puits constituant les dents d'une sorte de peigne vertical. Au contraire les zones désertes entourant les extrémités des dents de ce peigne forment des régions tubulaires 22, lesquelles repoussent les porteurs de charge et renforcent la caractère semi-isolant du substrat.

La résistance par mm de largeur de grille se trouve aussi divisée par un facteur non mégligeable.

A la fig. 3, on a représenté, en coupe transversale (et non plus longitudinale comme à la fig. 2) la réalisation de l'invention dans laquelle on a aussi appliqué la technologie de fabrication des peignes verticaux avec puits métallisés aux électrodes 3 et 4.

Toutefois on observe ici trois différences importantes:

1) La métallisation des puits 31 et 41 a été faite en utilisant des matériaux propres à former un bon contact ohmique (nickel, etc.).
2) Les puits 31 et 41 ne pénètrent que peu ou pas du tout dans la région du substrat 1.
3) On peut réaliser deux ou plusieurs rangées de puits pour chaque électrode, celle-ci recouvrant l'ensemble des puits de source ou de drain.

Dans cette réalisation la résistance ohmique et la résistance d'accès à la couche active sont divisées par un facteur non négligeable, ce qui contribue à améliorer encore le fonctionnement du transistor.

A la fig. 4, on a dessiné une coupe du transistor par un plan parallèle à la couche 2 et dans l'épaisseur de celle-ci. Dans cette variante on a réalisé deux rangées de puits 51 et 52, chaque rangée étant recouverte par une grille distincte $G_1$ ou $G_2$. On a représenté à titre d'exemple deux peignes verticaux de pas différents, les puits 51 étant moins espacés que les puits 52.

Il est possible de réaliser aussi deux grilles $G_1$ et $G_2$ de même pas mais dont les rangées soient décalées longitudinalement.

De tels transistors à effet de champ à deux grilles polarisées à des potentiels différents permettent de commander de différentes façons le courant délivré par le transistor et en outre de faire fonctionner le transistor en déphaseur. En effet, dans ce dernier cas les porteurs de charge, étant successivement déviés par les dents des deux peignes verticaux, ont des chemins parcourus variables en fonction des potentiels appliqués aux grilles $G_1$ et $G_2$.

En ce qui concerne le procédé de fabrication des puits métallisés dans le cas de la fig. 3, ce procédé doit être complété comme suit:

1) A l'étape (c) les puits destinés aux électrodes de source et de drain sont masqués pendant la métallisation à l'aide d'un produit de masquage électronique;
2) Dans une étape supplémentaire comprise entre les étapes (c) et (d), on trouve une opération analogue à celle de l'étape (c) dans laquelle les puits destinés à l'électrode de grille sont masqués pendant la métallisation, à l'aide d'un produit de masquage électronique;
3) A l'étape (d) le deuxième masque délimite uniquement la surface de la future électrode de grille;
4) Après l'étape (e), on effectue des opérations analogues à celles des étapes (d) et (e) pour réaliser les électrodes de source et de drain à l'emplacement des puits correspondants.

**Revendications**

1. Transistor à effet de champ, de type planar, comportant, supporté par un substrat (1) en matériau semi-isolant, une couche active (2) en matériau semiconducteur sur laquelle sont déposées les métallisations des électrodes de source et drain (3, 4) et de grille (6), ce transistor étant caractérisé en ce que, en vue de mieux contrôler le pincement du canal dans l'épaisseur de la couche active (2), les électrodes de source, grille et drain sont prolongées par une pluralité de puits métalliques (5, 31, 41), formant peigne et traversant la couch active (2) jusqu'à pénétrer dans le substrat (1), les puits métalliques (5) sous l'électrode de grille (6) formant un contact Schottky avec le matériau de la couche active (2) tandis que les puits métalliques (31, 41) sous les électrodes de source et drain (3, 4) forment en contact ohmique avec ledit matériau.

2. Transistor selon la revendication 1 caractérisé en ce qu'il comporte au moins une électrode supplémentaire de grille (G₂) comportant des puits métallisés (52).

3. Transistor selon la revendication 2, caractérisé en ce que la grille supplémentaire (G₂) diffère de la grille initiale (G₁) par un espacement différent des puits (51 et 52).

4. Transistor selon la revendication 2, caractérisé en ce que la grille supplémentaire (G₂) diffère de la grille initiale (G₁) par un décalage mutuel des rangées de puits (51 et 52) dans leurs plans parallèles.

5. Procédé de fabrication d'un transistor selon la revendication 1, caractérisé en ce qu'il comporte au moins les étapes suivantes:

a) Sur la face libre d'une couche de matériau semiconducteur (2) épitaxée sur un substrat semi-isolant (1), délimitation de trois rangées de petites surfaces de la couche (2) du solide semiconducteur par un premier masque résistant à la gravure ionique;

b) Formation de puits (5, 31, 41) par gravure ionique à travers les trous du masque formé à l'étape (a);

c) Métallisation de l'intérieur des puits (5, 31, 41) par pulvérisation cathodique de métaux susceptibles de former, avec le solide semiconducteur un contact Schottky pour la grille (5) et un contact ohmique pour la source et le drain (31, 41);

d) Remplacement du premier masque par un deuxième masque délimitant les surfaces englobant les rangées de puits (5, 31, 41);

e) Dépôt de métaux susceptibles de former avec le matériau semiconducteur sur les surfaces délimitées à l'étape (d) un contact Schottky en vue de constituer l'électrode de grille (6), et deux contacts ohmiques en vue de constituer les électrodes de source et drain (3, 4).

**Patentansprüche**

1. Feldeffekttransistor von Planartyp, mit einer von einem Substrat (1) aus halbisolierendem Material getragenen aktiven Schicht (2) aus Halbleitermaterial, auf der die Metallisierungen der Source- und Drain-Elektroden (3, 4) und die Gate-Elektrode (6) aufgebracht sind, wobei dieser Transistor dadurch gekennzeichnet ist, daß zur besseren Steuerung der Verengung des Kanals in der Dicke der aktiven Schicht (2) die Source-, Gate- und Drain-Elektrode verlängert sind durch eine Mehrzahl von metallischen Schächten (5, 31, 41), die einen Kamm bilden und die aktive Schicht (2) durchqueren und bis in das Substrat (1) eindringen, wobei die metallischen Schächte (5) unterhalb der Gate-Elektrode (6) einen Schottky-Kontakt mit dem Material der aktiven Schicht (2) bilden, während die metallischen Schächte (31, 41) unter den Source- und Drain-Elektroden (3, 4) einen ohmschen Kontakt mit dem genannten Material bilden.

2. Transistor nach Anspruch 1, dadurch gekennzeichnet, daß er wenigstens eine zusätzliche Gate-Elektrode (G₂) aufweist, welche metallisierte Schächte (52) umfaßt.

3. Transistor nach Anspruch 2, dadurch gekennzeichnet, daß das zusätzliche Gate (G₂) sich von dem ersteren Gate (G₁) durch unterschiedliche Abstände zwischen den Schächten (51 und 52) unterscheidet.

4. Transistor nach Anspruch 2, dadurch gekennzeichnet, daß das zusätzliche Gate (G₂) sich von dem ersteren Gate (G₁) durch eine gegenseitige Versetzung der Reihen von Schächten (51 und 52) in ihren parallelen Ebenen unterscheidet.

5. Verfahren zur Herstellung eines Transistors nach Anspruch 1, dadurch gekennzeichnet, daß es wenigstens die folgenden Schritte umfaßt:

a) auf der freien Fläche einer Schicht aus Halbleitermaterial (2), die epitaktisch auf einem halbisolierenden Substrat (1) aufgebracht ist, werden drei Reihen von kleinen Oberflächen der Schicht (2) des Halbleiterfestkörpers mittels einer ersten Maske begrenzt, die gegen Ionengravierung beständig ist;

b) mittels Ionengravierung durch die Löcher der im Schritt (a) gebildeten Maske hindurch werden Schächte (5, 31, 41) gebildet;

c) die Innenseite der Schächte (5, 31, 41) wird durch Katodenzerstäubung von Metallen metallisiert, die geeignet sind, um mit dem Halbleiterfestkörper einen Schottky-Kontakt zu bilden, was das Gate (5) anbetrifft, und einen ohmschen Kontakt zu bilden, was die Source- und die Drain-Elektrode (31, 41) anbetrifft;

d) Ersetzen der ersten Maske durch eine zweite Maske, welche Oberflächen begrenzt, die Reihen von Schächten (5, 31, 41) umfassen;

e) Ablagerung von Metallen, die geeignet sind, um mit dem Halbleitermaterial auf den im Schritt (d) begrenzten Oberflächen einen Schottky-Kontakt zu bilden, um die Gate-Elektrode (6) herzustellen, bzw. zwei ohmsche Kontakte zu bilden, um die Source- und Drain-Elektroden (3, 4) zu bilden.

**Claims**

1. Field-effect transistor of the planar type comprising supported by a substrate (1) of semiinsulating material an active layer (2) of semiconducteur material on which are deposited the metallizations of the source and drain electrodes (3, 4) and the gate electrode (6), this transistor being characterized in that for better control of the constriction of the channel in the thickness of the active layer (2) the source, gate and drain electrodes are lengthened by a plurality of metallic wells (5, 31, 41) forming a comb and traversing the active layer (2) and penetrating into the sibstrate (1), the metallic wells (5) forming beneath the gate electrode (6) a Schottky contact with the material of the active layer (2) whilst the metallic wells (31, 41) beneath the source and drain electrodes (3, 4) form an ohmic contact with said material.

2. Transistor according to claim 1, characterized in that it comprises at least one supplementary gate electrode ($G_2$) comprising metallic wells (52).

3. Transistor according to claim 2, characterized in that the supplementary gate ($G_2$) differs from the initial gate ($G_1$) in different spacings between the wells (51 and 52).

4. Transistor according to claim 2, characterized in that the supplementary gate ($G_2$) differs from the initial gate ($G_2$) in a mutual offsetting of the rows of wells (51 and 52) in their parallel planes.

5. Method of fabricating a transistor according to claim 1, characterized in that it comprises at least the following steps:

a) on the free face of a layer of semiconductor material (2) epitaxially deposited on a semiinsulating substrate (1), definition of three rows of small surfaces of the layer (2) of the semiconductor solid body by a first mask resistant to ionic engraving;

b) formation of wells (5, 31, 41) by ionic engraving through the holes of the mask formed in step (a);

c) metallization of the interior of the wells (5, 31, 41) by cathode sputtering of metals able to form with the semiconductor solid body a Schottky contact for the gate (5) and an ohmic contact for the source and rain (31, 41);

d) Replacement of the first mask by a second mask defining the surfaces including the rows of wells (5, 31, 41);

e) Deposition of metals able to form with the semiconductor material on the surfaces defined in step (d) a Schottky contact for forming the gate electrode (6) and two ohmic contacts for forming the source and drain electrodes (3, 4).

FIG.1

0 061 376

# FIG. 2

# FIG. 3

# FIG. 4